# EUROPEAN PATENT APPLICATION

(11) **EP 4 557 895 A1**
(43) Date of publication of application: **21.05.2025**
(21) Application number: 24212728.0
(22) Date of filing: 13.11.2024
(51) Int. Cl.: H05K 1/14, H05K 1/18, H05K 3/36, H05K 3/40

(54) **CLIPS SERVING AS VERTICAL INTERCONNECT**

(30) Priority: 17.11.2023 US 202363600230 P; 01.11.2024 US 202418935232
(71) Applicant: Analog Devices, Inc., Wilmington, MA 01887 (US)
(72) Inventor: PADUVALLI, Vikas, Wilmington, 01887 (US); PHAM, Hien Minh, Wilmington, 01887 (US)
(74) Representative: Yang, Shu

(57) **Abstract**

Clips serving as vertical interconnect are disclosed herein. In certain embodiments, an electronic assembly such as an electronic module includes a first circuit board and an electronic component attached to the first circuit board. The electronic component includes a dielectric body and at least one clip secured to the dielectric body. The clip is electrically connected to the first circuit board to operate as vertical interconnect.

## Description

### Field of the Disclosure

Embodiments of the invention relate to electronic systems, and more particularly, to vertical interconnect in electronic assemblies.

### BACKGROUND

An electronic module includes passive devices, active devices, and/or semiconductor dies interconnected to perform a particular function. Such an electronic module can also include pins for providing an electrical interface to connect the electronic module to a larger electronic system.

One example of an electronic module is a power module, which can include one or more switching regulators that operate in combination with one or more inductors to provide power regulation. For example, the switching regulator can employ switches (for instance, power transistors) coupled in series and/or parallel with an output terminal that provides an output voltage to a load through an inductor. Additionally, a controller turns the switches ON and OFF to control delivery of current pulses to the output terminal through the inductor, which converts the switched pulses into a steady load current. A power module can include a semiconductor die on which metal-oxide-semiconductor field-effect transistor (MOSFET) switches and a driver are formed. Such a semiconductor die is referred to as a driver and MOSFET (DrMOS) die or integrated circuit (IC).

### SUMMARY OF THE DISCLOSURE

Clips serving as vertical interconnect are disclosed herein. In certain embodiments, an electronic assembly such as an electronic module includes a first circuit board and an electronic component attached to the first circuit board. The electronic component includes a dielectric body and at least one clip secured to the dielectric body. The clip is electrically connected to the first circuit board to operate as vertical interconnect. For example, the clip can be used to electrically connect the first circuit board to a second circuit board that is attached to the electronic component opposite the first circuit board. By using clips as vertical interconnect, limitations in aspect ratio for vertical interconnect is avoided. Further, since the clips are securely held by the dielectric body, the clips are not subjected to tilt and/or twist like conventional vertical interconnect. Moreover, the clips can be implemented with tight spacing.

In one aspect, an electronic assembly includes a first circuit board and an electronic component attached to the first circuit board. The electronic component includes a dielectric body and a first clip secured to the dielectric body. The first clip is electrically connected to the first circuit board to operate as vertical interconnect.

In another aspect, a method of providing electrical connections in an electronic assembly is provided. The method includes securing a first clip to a dielectric body of an electronic component, attaching the electronic component to a first circuit board, and using the first clip as vertical interconnect.

In another aspect, an electronic component includes a dielectric body having a first surface, a second surface opposite the first surface, and a side. The electronic component further includes a first clip secured to the dielectric body to operate as vertical interconnect, the first clip providing an electrical connection from the first surface to the second surface along the side.

### BRIEF DESCRIPTION OF THE DRAWINGS

Figure 1 is a perspective view of one embodiment of an electronic component with clips serving as vertical interconnect.
Figure 2A is a side view of one embodiment of an electronic assembly using the electronic components of Figure 1 for providing vertical interconnects.
Figure 2B is a side view of another embodiment of an electronic assembly using the electronic components of Figure 1 for providing vertical interconnects.
Figure 3 is a perspective view of one embodiment of an inductor component with clips serving as vertical interconnect.
Figure 4 is a perspective view of another embodiment of an inductor component with clips serving as vertical interconnect.
Figure 5 is a perspective view of another embodiment of an inductor component with clips serving as vertical interconnect.
Figure 6 is a perspective view of another embodiment of an inductor component with clips serving as vertical interconnect.
Figure 7 is a perspective view of another embodiment of an inductor component with clips serving as vertical interconnect.
Figure 8 is a perspective view of one embodiment of a power module using the inductor components of Figure 7 as vertical interconnect.
Figure 9 is a circuit diagram of a power module according to one embodiment.

### DETAILED DESCRIPTION OF EMBODIMENTS

The following detailed description of embodiments presents various descriptions of specific embodiments of the invention. However, the invention can be embodied in a multitude of different ways. In this description, reference is made to the drawings where like reference numerals may indicate identical or functionally similar elements. It will be understood that elements illustrated in the figures are not necessarily drawn to scale. Moreover, it will be understood that certain embodiments can include more elements than illustrated in a drawing and/or a subset of the elements illustrated in a drawing. Further, some embodiments can incorporate any suitable combination of features from two or more drawings.

Vertical interconnect can be used to provide vertical electrical connections in a variety of electronic assemblies. For example, an electronic assembly, such as an electronic module, can include a first circuit board and a second circuit board that are electrically connected to one another by vertical interconnect.

Existing vertical interconnect suffers from various drawbacks. For example, certain vertical interconnects have limitations on aspect ratio, for instance, a height to width ratio of 2:1 or less. Thus, to achieve taller vertical interconnect, a footprint of the vertical interconnect increases to maintain the aspect ratio. Such an increase in footprint leads to the vertical interconnect occupying more space.

Another limitation of existing vertical interconnect is that it can be subjected to tilt and/or twist due to stress arising during assembly. Furthermore, such vertical interconnect can be treated as a component for certain assembly processes, and thus subject to component-to-component spacing limitations and a corresponding reduction in number of vertical interconnects per unit area. Moreover, certain assembly processes specify that all vertical interconnect is the same size, thus necessitating that common-sized vertical interconnect be used for both power and signals.

There is a need for improved vertical interconnect for electronic assemblies, including for power modules desiring to grow in a vertical direction to increase power density and/or lower thermal resistance.

Clips serving as vertical interconnect are disclosed herein. In certain embodiments, an electronic assembly such as an electronic module includes a first circuit board and an electronic component attached to the first circuit board. The electronic component includes a dielectric body and at least one clip secured to the dielectric body. The clip is electrically connected to the first circuit board to operate as vertical interconnect.

For example, the clip can be used to electrically connect the first circuit board to a second circuit board that is attached to the electronic component opposite the first circuit board.

By using clips as vertical interconnect, limitations in aspect ratio for vertical interconnect is avoided. Further, since the clips are securely held by the dielectric body, the clips are not subjected to tilt and/or twist like conventional vertical interconnect. Moreover, the clips can be implemented with tight spacing.

In certain implementations, two or more clips are secured to the dielectric body and used as vertical interconnect. When including multiple clips, the clips can have the same or different sizes, depending on application.

For example, when used to carry both power and signals, the clips can have different sizes for power connections relative to signal connections. For instance, a power supply voltage connection may be associated with higher transient current relative to a signal connection, and thus may be implemented with a larger size and lower resistivity. Accordingly, the clips can have varying sizes for power and signals, with each clip having a size tailored for the specific electrical connection that the clip is providing.

In certain implementations, each clip includes a top portion on a top surface of the dielectric body, a bottom portion on a bottom surface of the dielectric body, and a side portion connecting the top portion to the bottom portion along a side of the dielectric body.

Thus, the clips wrap around a side of the dielectric body to provide an electrical connection from the above the dielectric body to below the dielectric body. The clips can be made of metal, for instance, copper. The clips are also referred to herein as staples.

The clips can be attached to a wide variety of electronic components to facilitate providing vertical electrical connections in electronic assemblies, such as electronic modules.

In certain implementations, the electronic component corresponds to an inductor component. For example, the inductor component can include a dielectric body (for example, a ferrite core) through which one or more inductors (for instance, copper windings) are formed, and the clips can be secured to the dielectric body to provide vertical interconnect. In such implementations, a more compact and efficient power module is realized by providing vertical interconnect along the sides of the inductor component to allow more volume in the body for the inductors.

The clips can be attached to the dielectric body of the electronic component in any suitable way. In a first example, a clip is secured to a dielectric body using an adhesive. In a second example, a clip is plated on the dielectric body using any suitable plating process. In a third example, the clip is soldered to the dielectric body. In a fourth example, a recess is formed in the dielectric body, and the clip rests in the recess. Placing clips in recesses of the dielectric body can be particularly useful for implementations in which the clips having varying thicknesses and it is desirable for the clips to be co-planar with one another to provide a flat electrical interface to a circuit board. Thus, for example, a thicker clip for carrying power can be placed in a recess so that it is flush with thinner clips used for carrying signals.

In certain implementations, at least one semiconductor die is attached to the first circuit board. When implemented as a power module, the at least one semiconductor die (for instance, one or more DrMOS die) can operate in combination with an inductor of the inductor component to form a power module. For instance, the number of inductors included in the inductor component can correspond to a desired number of phases for power regulation, and thus a single-phase power module, a two-phase (2-phase) power module, four-phase (4-phase) power module, or other desired power module can be realized.

Surface mount components, such as capacitors, can also be attached in various locations in the electronic assembly. Such surface mount components can be included not only on a circuit board, but also on the electronic component that includes the clips. For example, surface mount components can be included on top, bottom, and/or side surfaces of the electronic component. Such surface mount components can be electrically connected to one or more of the clips to aid in achieving desired circuit operation.

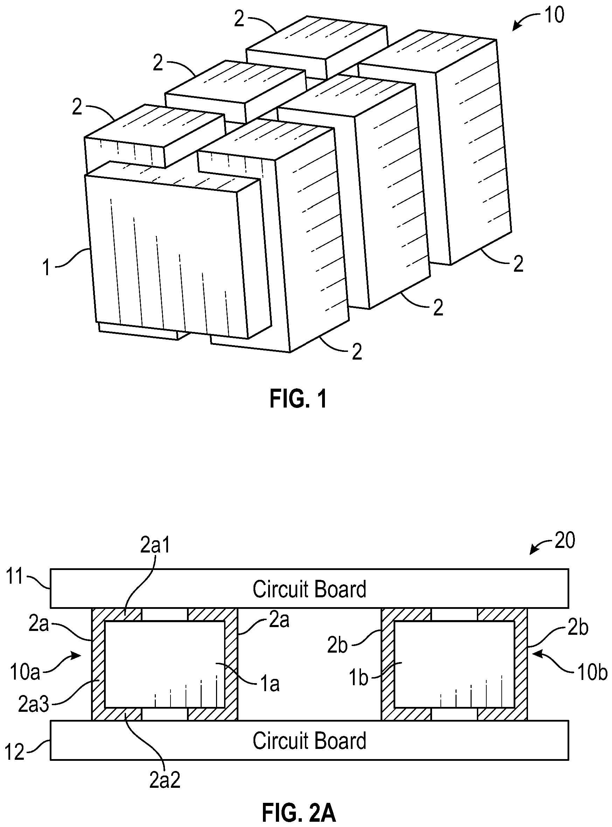

Figure 1 is a perspective view of one embodiment of an electronic component 10. The electronic component 10 includes a dielectric body 1 and clips 2. Each of the clips 2 is secured to the dielectric body to serve as vertical interconnect.

In the illustrated embodiment, the dielectric body 1 is shaped substantially as a rectangular prism. Additionally, each of the clips 2 wraps from a top surface to a bottom surface of the dielectric body 1 around a side of the dielectric body 1. Although an example of a dielectric body shaped as a rectangular prism is shown, the teachings herein are applicable to dielectric bodies of other shapes.

The clips 2 are electrically conductive, while the dielectric body 1 is nonconductive and formed of any suitable dielectric. In certain implementations, the clips 2 are formed of metal, for instance, copper.

In the illustrated embodiment, three of the clips 2 are secured to a left side of the dielectric body 1, while another three of the clips 2 are secured to a right side of the dielectric body 1. Although an example with six clips is shown, the electronic component 10 can include more or fewer clips. Further, the clips 2 can be arranged on the dielectric body 1 in other ways, for instance, on more or fewer sides of the dielectric body or in a different arrangement along the sides. Accordingly, other implementations are possible.

The clips 2 can be attached to the dielectric body 1 in any suitable way, for instance, using an adhesive. In some implementations, the clips 2 are plated to the dielectric body 1 using a plating process and/or placed in recesses in the dielectric body 1.

Figure 2A is a side view of one embodiment of an electronic assembly 20 using the electronic components of Figure 1 for providing vertical interconnects. The electronic assembly 10 includes a first circuit board 11, a second circuit board 12, a first electronic component 10a, and a second electronic component 10b.

In the illustrated embodiment, clips 2a are secured to the first electronic component 10a, while clips 2b are secured to the second electronic component 10b. The clips 2a/2b are used to provide electrical connections from the first circuit board 11 to the second circuit board 12. For example, the clips 2a/2b can be used to carry power (for example, a supply voltage and/or ground) and/or signals between the circuit boards 11/12 as desired.

By using clips as vertical interconnect, limitations in aspect ratio for vertical interconnect is avoided. Further, since the clips are securely held by the dielectric body, the clips are not subjected to tilt and/or twist like conventional vertical interconnect. Moreover, the clips can be implemented with tight spacing.

In certain implementations, each clip includes a top portion on a top surface of the dielectric body, a bottom portion on a bottom surface of the dielectric body, and a side portion connecting the top portion to the bottom portion along a side of the dielectric body. For example, the clip 2a includes a top portion 2a1, a bottom portion 2a2 and a side portion 2a3. Thus, the clips can wrap around a side of the dielectric body to provide an electrical connection from above the dielectric body to below the dielectric body.

As shown in Figure 2A, the top portion 2a1 is interposed between the dielectric body 1a and the first circuit board 11, while the bottom portion 2a2 is interposed between the dielectric body 1a and the second circuit board 12. The top portion 2a1 is electrically connected (for instance, soldered) to a corresponding electrical terminal of the first circuit board 11, while the bottom portion 2a2 is electrically connected (for instance, soldered) to a corresponding electrical terminal of the second circuit board 12.

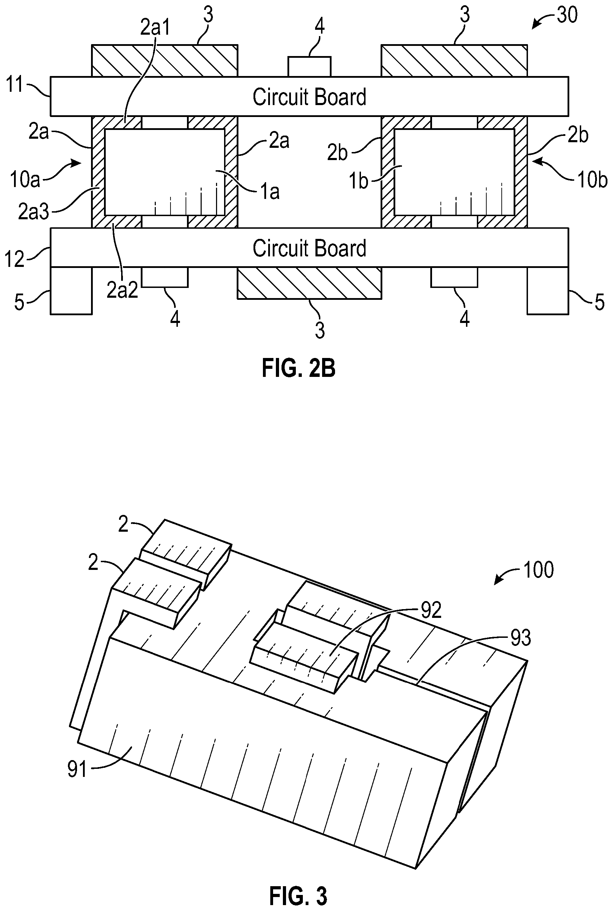

Figure 2B is a side view of another embodiment of an electronic assembly 30 using the electronic components of Figure 1 for providing vertical interconnects.

The electronic module 30 of Figure 2B is similar to the electronic assembly 20 of Figure 1B, except that the electronic assembly depicts various semiconductor dies 3, surface mount components 4, and electrical connectors 5 included on the circuit boards 11/12 as shown. The electronic circuitry on the first circuit board 11 can be electrically connected to the electronic circuitry of the second circuit board 12 using the clips 2a/2b. Thus, the semiconductor dies 3, surface mount components 4, and electrical connectors 5 can be interconnected as desired to achieve a particular function.

Although one example of electronic circuitry for each circuit board is shown, the circuit boards can include electronic circuitry implemented in a wide variety of ways. Accordingly, other implementations are possible.

Any of the electronic components herein can be included in an electronic assembly to provide vertical interconnects. In some implementations, the electronic assembly is an electronic module, such as a power module.

Figure 3 is a perspective view of one embodiment of an inductor component 100 with clips serving as vertical interconnect. The inductor component 100 includes a dielectric body 91 (for example, a ferrite core) through which an inductor 92 (for example, a copper winding) has been formed. The dielectric body 91 also includes a groove 93 through the dielectric body 91 to aid in achieving desired inductance characteristics for the inductor component 100.

As shown in Figure 3, clips 2 have been secured to a side of the dielectric body 91 of the inductor component 100.

Securing clips 2 to an inductor component to provide vertical interconnect can provide several advantages. For example, providing vertical interconnect along the sides of the inductor component 100 allow more volume for inductors. Furthermore, when used to provide vertical interconnect in a power module, the clips 2 increase the compactness and/or efficiency of the power module.

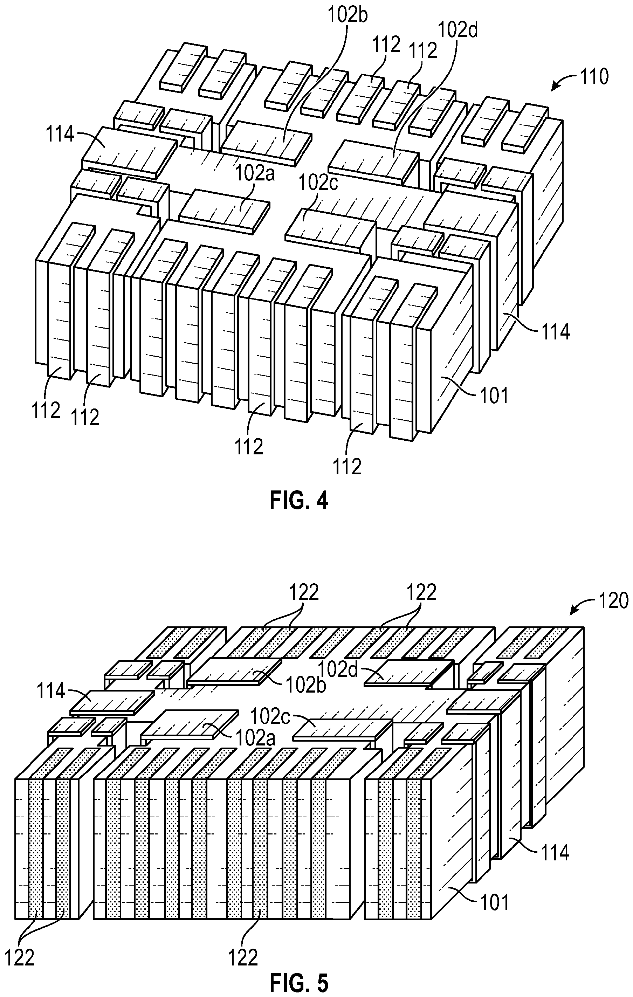

Figure 4 is a perspective view of another embodiment of an inductor component 110 with clips serving as vertical interconnect.

In the illustrated embodiment, the inductor component 110 includes a dielectric body 101 (for example, a ferrite core) that includes four inductors 102a/102b/102c/102d (for example, copper coils) formed through the dielectric body 101. Thus, four inductors 102a/102b/102c/102d are provided, which makes the inductor component 110 well-suited for a 4-phase power regulation application.

The inductor component 110 includes first clips 112 secured to the dielectric body 101 and of a first size (for instance, suitable for carrying signals) and second clips 114 secured to the dielectric body 101 and of a second size (for instance, suitable for carrying power).

In certain implementations, clips of different sizes are secured to a dielectric body of an electronic component.

For example, when used to carry both power and signals, the clips can have different sizes for power connections relative to signal connections. For instance, a power supply voltage connection may be associated with higher transient current relative to a signal connection, and thus may be implemented with a larger size and lower resistivity. Accordingly, the clips can have varying sizes for power and signals, with each clip having a size tailored for the specific electrical connection that the clip is providing.

Figure 5 is a perspective view of another embodiment of an inductor component 120 with clips serving as vertical interconnect.

The inductor component 120 of Figure 5 is similar to the inductor component 110 of Figure 4, except that the inductor component 120 of Figure 5 includes first clips 122 that are plated to the dielectric body 101. The first clips 122 can be used for carrying signals and/or providing other desired electrical connections.

Thus, a combination of first clips 122 that are plated and second clips 114 that are not plated are secured to the dielectric body 101, in this embodiment. In certain implementations, the second clips 114 are wider and thicker (for example, to carry power) than the first clips 122 and are secured to the dielectric body 101 using an adhesive.

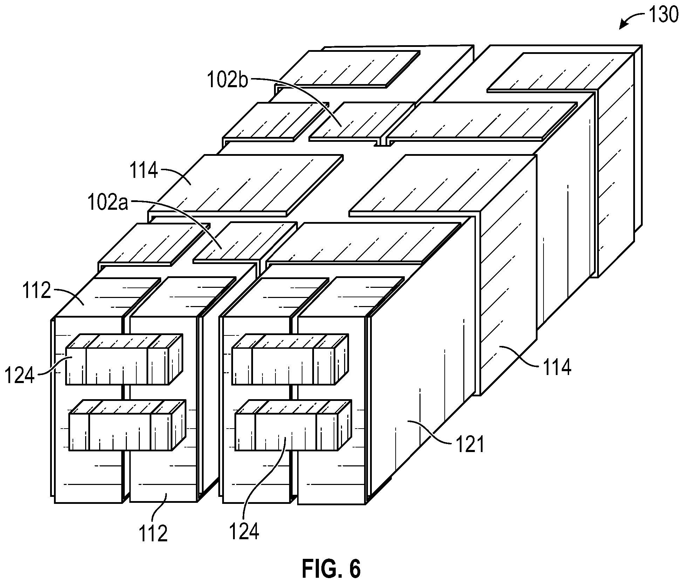

Figure 6 is a perspective view of another embodiment of an inductor component 130 with clips serving as vertical interconnect.

In the illustrated embodiment, the inductor component 130 includes a dielectric body 121 (for example, a ferrite core) that includes two inductors 102a/102b (for example, copper coils) formed through the dielectric body 121. The inductor component 130 can be used to provide 2-phase power regulation.

The inductor component 130 includes clips 112/114 secured to dielectric body 121. As shown in Figure 6, surface mount components 124, such as capacitors, are connected across some of the clips 112.

By implementing the inductor component 130 in this manner, a more compact electronic assembly can be realized. For example, in a power regulation application, surface mount capacitors can be placed across clips of the inductor component to achieve a more compact power module. In some implementations, the surface mount components 124 are soldered to the clips 112. In such implementations, epoxy can be added to secure the components 124 to prevent fall-off during reflow and/or high temperature solder can be used.

Although shown as being attached to a side surface of the inductor component 130, surface mount components 124 can be included on any surface of the dielectric body 121.

When included on the top or bottom surface of a dielectric body, a recess can be formed in dielectric body and/or in a circuit board to provide clearance for the surface mount components when the electronic component is attached to the circuit board.

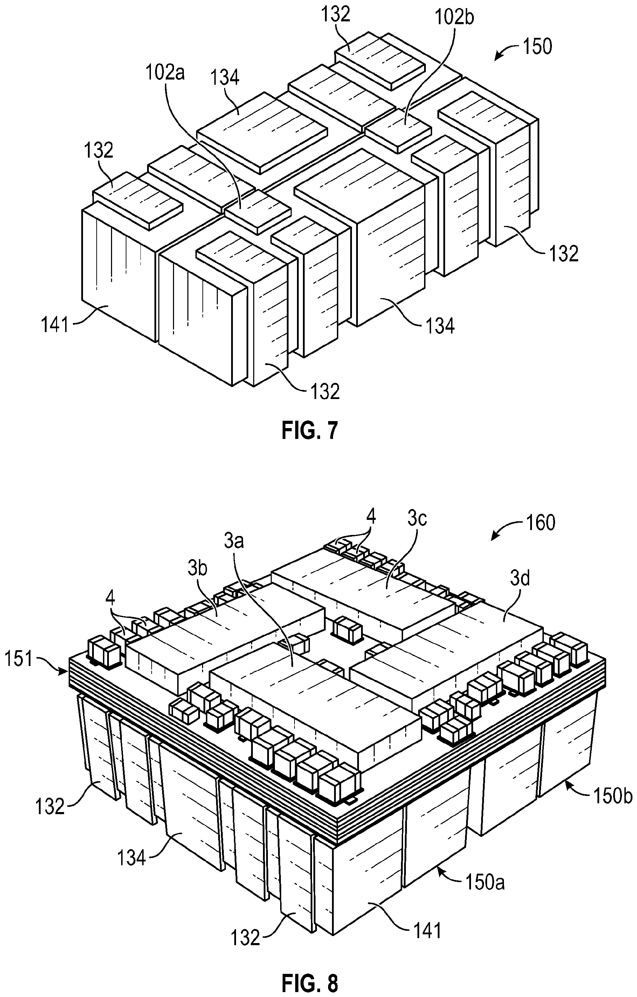

Figure 7 is a perspective view of another embodiment of an inductor component 150 with clips serving as vertical interconnect.

The inductor component 150 includes a dielectric body 141 (for example, a ferrite core) that includes two inductors 102a/102b (for example, copper coils) formed through the dielectric body 141.

The inductor component 110 includes first clips 132 secured to the dielectric body 141 and of a first size (for instance, suitable for carrying signals) and second clips 134 secured to the dielectric body 141 and of a second size (for instance, suitable for carrying power).

Figure 8 is a perspective view of one embodiment of a power module 160 using the inductor components of Figure 7 as vertical interconnect. For example, the power module 160 includes a circuit board 151, a first inductor component 150a attached to a bottom surface of the circuit board 151, and a second inductor component 150b attached to the bottom surface of the circuit board 151.

The power module 160 of Figure 8 includes two of the inductor components of Figure 7. Since the inductor components each include two inductors, the power module 160 includes four inductors and thus operates as a 4-phase power regulation module, in this example.

In the illustrated embodiment, a top side of the circuit board 151 includes surface mount components 4 and a first semiconductor die 3a, a second semiconductor die 3b, a third semiconductor 3c, and a fourth semiconductor die 3d. In certain implementations, each of the semiconductor dies 3a-3d correspond to a DrMOS die including a regulator that regulates a current through a corresponding one of the inductors of inductors components 150a/150b.

The clips 132/134 are used to carry signals and power between the circuitry on the circuit board 151 and another circuit board (for instance, a customer circuit board to which the power module 160 is soldered to when deployed for a given application).

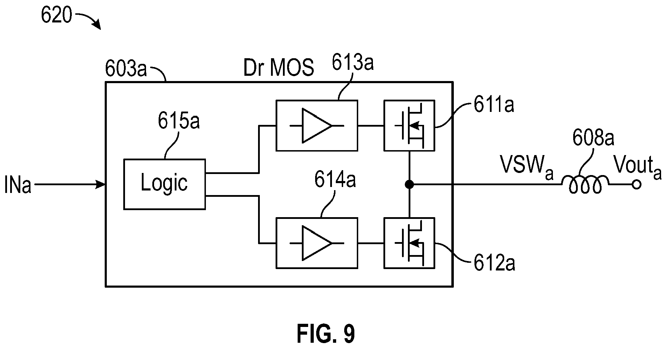

Figure 9 is a circuit diagram of a power module 620 according to one embodiment.

The circuit diagram depicts an example of power regulation circuitry for a single phase of power regulation. However, the power regulation circuitry can be replicated to provide regulation for multiple phases. For example, the circuitry can be replicated four times to provide regulation in a 4-phase power module, such as the power module 160 of Figure 8.

Accordingly, although an example of a single-phase power module is depicted, a power module can include more phases as needed for a particular application. Furthermore, although one example of circuitry suitable for power regulation is shown, circuitry for a power module can be implemented in other ways.

In the illustrated embodiment, the power module 620 includes a DrMOS die 603a that regulates a current through an inductor 608a. The DrMOS die 603a includes a first high side power MOSFET 611a, a first low side power MOSFET 612a, a first high side driver 613a, a first low side driver 614a, and a driver logic circuit 615a.

Although one example of a DrMOS die is shown, DrMOS dies can be implemented in other ways. Accordingly, other implementations are possible. Furthermore, although certain circuits of the DrMOS dies are depicted, DrMOS dies can include other circuitry and/or other pin configurations.

In the illustrated embodiment, an input control signal INa is provided to the logic 615a. The logic 615a controls driver signals to the high side driver 613a and the low side driver 614a, which control the high side power MOSFET 611a and low side power MOSFET 612a, respectively. The high side power MOSFET 611a and low side power MOSFET 612a are coupled to a first terminal VSWa of the inductor 608a to form a half bridge circuit of a switching regulator, such as a buck converter. The MOSFETs 612a/612b are switched on and off to control a current provided to the inductor 608a. A second terminal of the inductor 608a electrically connects to an output voltage pin VOUTa.

### Applications

Devices employing the above-described schemes can be implemented into various electronic devices in a wide range of applications including, but not limited to, bus converters, high current distributed power systems, telecom systems, datacom systems, storage systems, and automotive systems. Thus, examples of electronic devices that can be implemented with the power modules herein include, but are not limited to, communication systems, consumer electronic products, electronic test equipment, communication infrastructure, servers, automobiles, etc.

### Conclusion

The foregoing description may refer to elements or features as being "connected" or "coupled" together. As used herein, unless expressly stated otherwise, "connected" means that one element/feature is directly or indirectly connected to another element/feature, and not necessarily mechanically. Likewise, unless expressly stated otherwise, "coupled" means that one element/feature is directly or indirectly coupled to another element/feature, and not necessarily mechanically. Thus, although the various schematics shown in the figures depict example arrangements of elements and components, additional intervening elements, devices, features, or components may be present in an actual embodiment (assuming that the functionality of the depicted circuits is not adversely affected).

While certain embodiments have been described, these embodiments have been presented by way of example only and are not intended to limit the scope of the disclosure. Indeed, the novel apparatus, methods, and systems described herein may be embodied in a variety of other forms; furthermore, various omissions, substitutions, and changes in the form of the methods and systems described herein may be made without departing from the spirit of the disclosure. For example, while the disclosed embodiments are presented in a given arrangement, alternative embodiments may perform similar functionalities with different components and/or circuit topologies, and some elements may be deleted, moved, added, subdivided, combined, and/or modified. Each of these elements may be implemented in a variety of different ways. Any suitable combination of the elements and acts of the various embodiments described above can be combined to provide further embodiments. Accordingly, the scope of the present invention is defined only by reference to the appended claims.

Although the claims presented here are in single dependency format for filing at the USPTO, it is to be understood that any claim may depend on any preceding claim of the same type except when that is clearly not technically feasible.

### Numbered aspects

By way of non-limiting example, some aspects of the disclosure are set out in the following numbered clauses.
Numbered Clause 1. An electronic assembly comprising:
   a first circuit board; and
   an electronic component attached to the first circuit board, the electronic component including a dielectric body and a first clip secured to the dielectric body,
   wherein the first clip is electrically connected to the first circuit board to operate as vertical interconnect.
Numbered Clause 2. The electronic assembly of Numbered Clause 1, further comprising a second circuit board attached to the electronic component opposite the first circuit board, wherein first clip electrically connects the first circuit board to the second circuit board.
Numbered Clause 3. The electronic assembly of Numbered Clause 1 or 2, wherein the electronic component is an inductor component.
Numbered Clause 4. The electronic assembly of Numbered Clause 3, wherein the dielectric body is a ferrite core, the inductor component including one or more inductors formed through the ferrite core.
Numbered Clause 5. The electronic assembly of any preceding Numbered Clause, wherein the first clip comprises a metal.
Numbered Clause 6. The electronic assembly of Numbered Clause 5, wherein the metal is copper.
Numbered Clause 7. The electronic assembly of any preceding Numbered Clause, further comprising a second clip secured to the electronic component and electrically connected to the first circuit board to operate as vertical interconnect.
Numbered Clause 8. The electronic assembly of Numbered Clause 7, wherein the first clip carries a signal and the second clip carries power.
Numbered Clause 9. The electronic assembly of any preceding Numbered Clause, wherein the first clip and the second clip have different sizes.
Numbered Clause 10. The electronic assembly of any preceding Numbered Clause, further comprising a component mounted across the first clip and the second clip.
Numbered Clause 11. The electronic assembly of any preceding Numbered Clause, wherein the first clip is plated on the dielectric body.
Numbered Clause 12. The electronic assembly of any preceding Numbered Clause, wherein the first clip is attached to the dielectric body by an adhesive.
Numbered Clause 13. A method of providing electrical connections in an electronic assembly, the method comprising:
   securing a first clip to a dielectric body of an electronic component;
   attaching the electronic component to a first circuit board; and
   using the first clip as vertical interconnect.
Numbered Clause 14. The method of Numbered Clause 13, further comprising attaching a second circuit board to the electronic component opposite the first circuit board and using the first clip as vertical interconnect between the first circuit board to the second circuit board.
Numbered Clause 15. The method of Numbered Clause 13 or 14, wherein the electronic component is an inductor component including at least one inductor formed through the dielectric body.
Numbered Clause 16. The method of any of Numbered Clauses 13 to 15, wherein the first clip comprises a metal.
Numbered Clause 17. The method of any of Numbered Clauses 13 to 16, further securing a second clip to the electronic component, and using the second clip as vertical interconnect.
Numbered Clause 18. The method of Numbered Clause 17, further comprising carrying a signal using the first clip and carrying power using the second clip.
Numbered Clause 19. An electronic component comprising:
   a dielectric body having a first surface, a second surface opposite the first surface, and a side; and
   a first clip secured to the dielectric body to operate as vertical interconnect, the first clip providing an electrical connection from the first surface to the second surface along the side.
Numbered Clause 20. The electronic component of Numbered Clause 19, further comprising an inductor formed through the dielectric body.

## Claims

1. An electronic assembly comprising:
a first circuit board; and
an electronic component attached to the first circuit board, the electronic component including a dielectric body and a first clip secured to the dielectric body,
wherein the first clip is electrically connected to the first circuit board to operate as vertical interconnect.

2. The electronic assembly of claim 1, further comprising a second circuit board attached to the electronic component opposite the first circuit board, wherein first clip electrically connects the first circuit board to the second circuit board.

3. The electronic assembly of claim 1 or 2, wherein the electronic component is an inductor component, preferably wherein the dielectric body is a ferrite core, the inductor component including one or more inductors formed through the ferrite core.

4. The electronic assembly of any preceding claim, wherein the first clip comprises a metal, preferably wherein the metal is copper.

5. The electronic assembly of any preceding claim, further comprising a second clip secured to the electronic component and electrically connected to the first circuit board to operate as vertical interconnect, preferably wherein the first clip carries a signal and the second clip carries power.

6. The electronic assembly of any preceding claim, wherein the first clip and the second clip have different sizes.

7. The electronic assembly of any preceding claim, further comprising a component mounted across the first clip and the second clip.

8. The electronic assembly of any preceding claim, wherein the first clip is plated on the dielectric body and/or wherein the first clip is attached to the dielectric body by an adhesive.

9. A method of providing electrical connections in an electronic assembly, the method comprising:
securing a first clip to a dielectric body of an electronic component;
attaching the electronic component to a first circuit board; and
using the first clip as vertical interconnect.

10. The method of claim 9, further comprising attaching a second circuit board to the electronic component opposite the first circuit board and using the first clip as vertical interconnect between the first circuit board to the second circuit board.

11. The method of claim 9 or 10, wherein the electronic component is an inductor component including at least one inductor formed through the dielectric body.

12. The method of any of claims 9 to 11, wherein the first clip comprises a metal.

13. The method of any of claims 9 to 12, further securing a second clip to the electronic component, and using the second clip as vertical interconnect, preferably further comprising carrying a signal using the first clip and carrying power using the second clip.

14. An electronic component comprising:
a dielectric body having a first surface, a second surface opposite the first surface, and a side; and
a first clip secured to the dielectric body to operate as vertical interconnect, the first clip providing an electrical connection from the first surface to the second surface along the side.

15. The electronic component of claim 14, further comprising an inductor formed through the dielectric body.
